(19) Europäisches Patentamt / European Patent Office / Office européen des brevets

(11) **EP 3 907 513 B1**

(12) **FASCICULE DE BREVET EUROPEEN**

(45) Date de publication et mention de la délivrance du brevet:
**10.04.2024 Bulletin 2024/15**

(21) Numéro de dépôt: **21172018.0**

(22) Date de dépôt: **04.05.2021**

(51) Classification Internationale des Brevets (IPC):
***G01R 15/24*** *(2006.01)*

(52) Classification Coopérative des Brevets (CPC):
**G01R 15/246; G01R 33/0322;** Y02E 60/10

(54) **CAPTEUR DE COURANT BASÉ SUR L'EFFET FARADAY DANS UN GAZ ATOMIQUE**

STROMSENSOR, DER AUF DEM FARADAY-EFFEKT IN EINEM ATOMGAS BERUHT

CURRENT SENSOR BASED ON THE FARADAY EFFECT IN AN ATOMIC GAS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.05.2020 FR 2004486**

(43) Date de publication de la demande:
**10.11.2021 Bulletin 2021/45**

(73) Titulaire: **Commissariat à l'énergie atomique et aux énergies alternatives
75015 Paris (FR)**

(72) Inventeur: **PALACIOS LALOY, Agustin
38054 GRENOBLE Cedex 09 (FR)**

(74) Mandataire: **Brevalex
Tour Trinity
1 B Place de la Défense
92400 Courbevoie (FR)**

(56) Documents cités:
EP-A1- 3 524 990          WO-A1-2019/122693
FR-A1- 3 062 922          KR-B1- 101 633 500
US-A- 6 114 846           US-A- 6 154 022
US-A1- 2013 093 421

# Description

## DOMAINE TECHNIQUE

Le domaine de l'invention est celui de la mesure de courants électriques au moyen de la propagation d'ondes lumineuses sous l'influence de l'effet Faraday autour d'un conducteur.

## TECHNIQUE ANTÉRIEURE

La mesure exacte et sans contact de courants de moyenne intensité (inférieurs à 1000 ou 1500 A) est souhaitable notamment pour des systèmes électriques incluant des batteries Li-ion, par exemple dans le domaine de l'aéronautique ou dans celui des réseaux électriques intelligents aptes à mobiliser des capacités de stockage connectées, telles que des batteries automobiles.

Une telle mesure sans contact offre tout d'abord la possibilité d'installer et de désinstaller les capteurs de courant, par exemple pour une maintenance, sans avoir à interrompre le courant du circuit qui est mesuré. Elle présente par ailleurs l'avantage d'une absence de contacts galvaniques entre le capteur de courant et le circuit dont il mesure le courant. Ces contacts sont en effet souvent sujets à un vieillissement progressif qui fait augmenter leur résistance électrique au cours du temps, ce qui résulte dans des pertes indésirables par effet Joule ainsi que des erreurs de mesure croissantes dans le temps qui requièrent une re-calibration périodique des capteurs de courant.

Les batteries de type Li-ion disposent d'avantages substantiels, notamment en termes de capacités de stockage, mais ne présentent pas une évolution significative de tension sur leur courbe de décharge. Ainsi, contrairement à d'autres batteries dont l'estimation de charge peut être obtenue de manière fiable par une mesure immédiate de tension, la mesure de tension ne fournit aucune indication sur l'état de charge d'une batterie Li-ion. Il est donc nécessaire pour estimer la charge d'une telle batterie de réaliser une mesure des courants entrants et sortants de la batterie, et les intégrer dans le temps. Toute inexactitude dans cette mesure, notamment tout décalage significatif du zéro, résulte dans de fortes erreurs d'estimation de charge car ces erreurs sont intégrées pendant des temps qui, pour des nombreuses applications, peuvent atteindre plusieurs jours. Il est donc important de disposer de très bonnes justesses de mesure du courant (de l'ordre de 1/1000 voire de 1/10000), et notamment une immunité de la mesure lue sur un capteur aux courants autres que celui mesuré (par exemple d'autres batteries présentes dans le coeur électrique d'un avion ou d'autres véhicules en cours de recharge à proximité du véhicule dont la batterie est équipée du capteur de courant considéré).

Une mesure du courant I totalement insensible aux courants extérieurs peut être obtenue par l'intégrale d'Ampère

$$I = \frac{1}{\mu_0} \oint_C \vec{B} \cdot \vec{dl}$$

, où C est un contour fermé autour de la ligne de courant à mesurer et où toutes les lignes de courant qu'il ne faut pas mesurer sont extérieures à ce contour.

Différents types de capteurs ont tenté de mesurer le terme de droite de cette égalité. Par exemple, dans des cas où des symétries sont présentes, il est possible d'approximer l'intégrale par une somme de mesures ponctuelles du champ magnétique B tangentielles à la trajectoire considérée. Il est également possible d'utiliser un concentrateur de flux de matériau ferromagnétique en forme de tore discontinu. La quasi-intégralité du flux créé par les courants à l'intérieur du concentrateur est alors concentrée à l'entrefer et une mesure ponctuelle dans cette région permet d'avoir une bonne estimation de l'intégrale d'Ampère pour peu que les lignes de champ normales à la surface de la fraction manquante de tore aient une intensité négligeable. Ce principe est mis en oeuvre notamment dans des mesures de courant exploitant des capteurs à effet Hall couplés à des concentrateurs de flux.

Une autre solution pour mesurer l'intégrale d'Ampère repose sur un effet magnéto-optique, en l'occurrence l'effet Faraday qui consiste en une rotation du plan de polarisation de la lumière d'un angle $\varphi$ proportionnel au champ magnétique longitudinal à la propagation de cette lumière. En présence d'un champ magnétique inhomogène, l'angle total de rotation de ce plan de polarisation s'écrit $\varphi = v \oint_C \vec{B} \cdot \vec{dl}$, où $v$ est une constante dépendante du matériau et de la longueur d'onde de la lumière qui reçoit le nom de constante de Verdet. Cette intégrale curviligne étant strictement proportionnelle à l'intégrale d'Ampère, il est possible de mesurer le courant directement par la rotation de polarisation d'une lumière se propageant sur une trajectoire fermée autour du conducteur dans lequel se propage le courant à mesurer, avec une constante de proportionnalité qui peut être déterminée soit par un calcul, soit par une calibration préalable.

Cet effet magnéto-optique est par exemple exploité par les capteurs de courant FOCS (pour « Fibre-Optic Current Sensor ») qui sont dotés d'une fibre optique positionnée de manière à entourer la ligne de courant. De tels capteurs présentent une justesse tout à fait remarquable (meilleure que 1/1000) mais, du fait de la faible constante de Verdet des fibres, ils sont destinés à des mesures de courants forts (500 kA nominaux par exemple). Par ailleurs, la stabilisation mécanique de la fibre (face aux vibrations, au vieillissement, à la plasticité, etc. pour éviter que des effets opto-mécaniques perturbent la mesure) constitue un aspect délicat de par le fait que les milieux matériels sont inévitablement sujets à des dérives au cours du temps et à une variabilité de leurs comportements. Par ailleurs, les documents WO 2019/122693 A1 et US 6 154 022 A représentent des documents pertinents de l'état de la technique.

## EXPOSÉ DE L'INVENTION

L'invention a pour objectif de proposer un capteur de courant exploitant la rotation Faraday qui ne présente pas les inconvénients susmentionnés des capteurs à fibre optique et qui soit notamment adapté à la mesure de courants de moyenne intensité. A cet effet, l'invention propose un capteur magnéto-optique d'un courant circulant dans un conducteur selon la revendication 1 et une méthode de mesure associée selon la revendication 12.

Certains aspects préférés mais non limitatifs de ce capteur de courant sont les suivants :

- le faisceau optique fourni par la source optique est décalé en longueur d'onde par rapport au centre de la raie transition atomique d'une moitié de la largeur à mi-hauteur de ladite raie ;
- le gaz atomique est de l'hélium-4 et ladite raie est la raie D2 ;
- il comprend en outre un modulateur de la longueur d'onde du faisceau optique fourni par la source de lumière et un système d'asservissement de la source de lumière configuré pour maintenir le décalage en longueur d'onde du faisceau optique par rapport au centre de ladite raie ;
- il comprend en outre un modulateur configuré pour moduler l'amplitude ou la fréquence du faisceau optique fourni par la source de lumière ;
- il comprend des miroirs agencés le long du parcours optique ;
- la cellule est annulaire ;
- l'analyseur de polarisation est un analyseur de polarisation linéaire configuré pour réaliser une mesure différentielle d'une composante de polarisation verticale et d'une composante de polarisation horizontale du faisceau optique ayant parcouru le chemin optique ;
- l'analyseur de polarisation linéaire comprend un séparateur de polarisation apte à séparer sur un premier et un deuxième chemin la composante de polarisation verticale et la composante de polarisation horizontale et un photodétecteur sur chacun des premier et deuxième chemins ;
- l'analyseur de polarisation est un analyseur de polarisation circulaire configuré pour réaliser une mesure différentielle d'une composante de polarisation circulaire droite et d'une composante de polarisation circulaire gauche du faisceau optique ayant parcouru le chemin optique ;
- l'analyseur de polarisation circulaire comprend une lame quart d'onde, un séparateur de polarisation apte à séparer sur un premier et un deuxième chemin la composante de polarisation circulaire droite et la composante de polarisation circulaire gauche et un photodétecteur sur chacun des premier et deuxième chemins.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

La figure 1 est un schéma d'un magnétomètre selon un premier exemple de réalisation de l'invention ;
La figure 2 est un schéma d'un magnétomètre selon un deuxième exemple de réalisation de l'invention.

## DESCRIPTION DÉTAILLÉE DES MODES DE RÉALISATION

L'invention propose un capteur magnéto-optique d'un courant circulant dans un conducteur. Ce capteur réalise une mesure du courant au moyen d'un faisceau lumineux qui se propage sur une trajectoire fermée qui entoure le conducteur, ladite mesure étant basée sur la rotation de Faraday (rotation du plan de polarisation de la lumière) non pas dans un milieu d'état solide mais dans un gaz atomique, par exemple de l'hélium-4 métastable ou un alcalin.

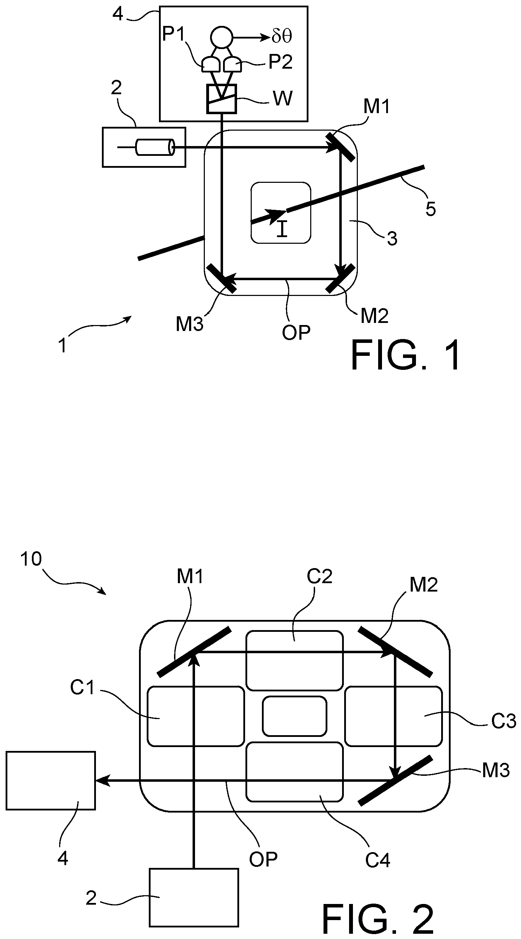

En référence aux figures 1 et 2, l'invention porte ainsi sur un capteur magnéto-optique 1, 10 d'un courant I circulant dans un conducteur 5, ledit capteur comprenant :

- une source de lumière 2 apte à fournir un faisceau optique polarisé linéairement, et
- un analyseur de polarisation 4 configuré pour réaliser une mesure différentielle de deux composantes de polarisation du faisceau optique polarisé linéairement ayant parcouru un chemin optique OP arrangé entre la source de lumière et l'analyseur de polarisation, ledit chemin optique formant une trajectoire fermée autour du conducteur 5.

Dans le capteur selon l'invention, au moins une cellule 3, C1-C4 contenant un gaz atomique est agencée le long du parcours optique. Le gaz atomique est ainsi présent le long de la trajectoire du faisceau optique sur le chemin optique OP entourant le conducteur. Le gaz atomique est de préférence présent tout au long du chemin optique OP, avec éventuellement une ou plusieurs régions de discontinuité dont la longueur accumulée est négligeable (par exemple inférieure à 1% ou 1‰) par rapport à la longueur totale du chemin optique OP.

Comme représenté sur la figure 1, le gaz atomique formant l'élément sensible du capteur selon l'invention peut être renfermé dans une cellule annulaire 3 au centre de laquelle, en utilisation, passe le conducteur 5 dans lequel circule le courant I à mesurer. La cellule annulaire peut être équipée de miroirs de renvoi M1-M3 permettant à la lumière incidente de réaliser une trajectoire fermée et sortir de la cellule à un point de sortie qui est par exemple proche du point d'entrée du chemin optique.

Alternativement, comme représenté sur la figure 2, le capteur peut comporter une pluralité de cellules C1-C4, par exemple quatre, agencées le long du parcours optique OP et des miroirs de renvoi M1-M3 permettant à la lumière de traverser chacune des cellules C1-C4 en réalisant la trajectoire fermée autour du conducteur. Dans cette alternative, la longueur des régions de discontinuité séparant les cellules n'est pas négligeable au sens indiqué précédemment. En conséquence, ce capteur présente des imperfections de mesure. Toutefois, en l'utilisant des configurations particulières, des considérations géométriques permettent de corriger ces imperfections de mesure.

Chaque cellule 3, C1-C4 contient une espèce atomique sensible au champ magnétique : il peut s'agir par exemple d'une cellule de verre contenant des atomes d'hélium-4 porté à son état métastable par des moyens d'excitations bien connu dans le domaine, d'une cellule de verre contenant des atomes d'alcalins présentant une densité significative dans la phase gazeuse comme résultat d'un chauffage à une température supérieure à la température ambiante ou bien encore d'un cristal de diamant contenant des impuretés d'azotes connues comme centres NV dans la littérature.

La source de lumière 2 peut comprendre une diode laser apte à émettre le faisceau optique, ledit faisceau étant polarisé linéairement (par exemple avec un taux de rejection de polarisations parasites supérieur à 25 dB) au moyen d'un polariseur intercalé entre la diode laser et le chemin optique ou directement intégré à la diode laser 2. La source de lumière 2 peut également comprendre un collimateur permettant de fixer la direction d'incidence du faisceau optique sur le point d'entrée du chemin optique OP.

A l'issue du parcours du chemin optique OP, la variation de la polarisation du faisceau optique est analysée par un analyseur linéaire ou circulaire. Plus précisément, la rotation de polarisation dans le cas d'un analyseur circulaire, ou le changement d'ellipticité dans le cas d'un analyseur circulaire, est analysée car proportionnelle au courant circulant dans le conducteur.

Dans une première variante, l'analyseur de polarisation est un analyseur de polarisation linéaire configuré pour réaliser une mesure différentielle d'une composante de polarisation verticale et d'une composante de polarisation horizontale du faisceau optique ayant parcouru le chemin optique. Comme représenté sur la figure 1, l'analyseur de polarisation linéaire peut comprendre un séparateur de polarisation W, par exemple un cube de Wollaston, apte à séparer sur un premier et un deuxième chemin la composante de polarisation verticale et la composante de polarisation horizontale et un photodétecteur P1, P2 sur chacun des premier et deuxième chemins. Les deux photodétecteurs P1, P2 permettent de mesurer le rapport entre les puissances des deux polarisations linéaires dont les axes correspondent à ceux du cube séparateur.

Dans le cadre de cette variante, la polarisation de la lumière envoyée est à 45° de l'axe de symétrie de la cellule annulaire, qu'on décrira par la suite comme direction verticale. A la sortie de la cellule, la lumière est analysée en polarisation à l'aide d'un cube séparateur. La composante polarisée verticalement et celle polarisée horizontalement sont photo-détectées par deux photodiodes connectées à des amplificateurs de trans-impédance, à la sortie desquels on retrouve des signaux $V_{vert}$ et $V_{horiz}$ respectivement. L'angle de rotation de polarisation peut se déduire de ces deux tensions par la relation

$$\delta\theta = \frac{V_{vert} - V_{horiz}}{2(V_{vert} + V_{horiz})}$$

. Lorsque la longueur d'onde de la lumière est placée de telle manière à être désaccordée d'une demie-largeur de raie par rapport à une transition atomique, par exemple $D_0$ ou $D_2$ dans le cas de l'hélium, cet angle de rotation $\delta\theta$ est strictement proportionnel au courant circulant dans le conducteur, et ne présente aucune dépendance significative avec les champs et courants situés à proximité du capteur et qui ne traversent pas le trou central de la cellule annulaire.

Dans une deuxième variante, l'analyseur de polarisation est un analyseur de polarisation circulaire configuré pour réaliser une mesure différentielle d'une composante de polarisation circulaire droite et d'une composante de polarisation circulaire gauche du faisceau optique ayant parcouru le chemin optique. L'analyseur de polarisation circulaire peut comprendre une lame de retard quart d'onde qui précède un séparateur de polarisation apte à séparer sur un premier et un deuxième chemin la composante de polarisation circulaire droite et la composante de polarisation circulaire gauche et un photodétecteur sur chacun des premier et deuxième chemins. L'axe rapide forme un angle de 45° avec l'axe d'analyse du séparateur.

En physique atomique, et notamment en magnétométrie à pompage optique, il est habituel d'utiliser la terminologie « effet Faraday » pour parler de mesures optiques d'états atomiques réalisées avec une lumière polarisée linéairement et décalée en longueur d'onde par rapport à une transition optique donnée. Le plan de polarisation de cette lumière subit alors une rotation qui est dépendante de l'état atomique, plus concrètement proportionnelle à la valeur moyenne de la composante du moment magnétique des atomes le long de la trajectoire de propagation de la lumière.

Il faut toutefois noter que cela ne correspond pas à l'effet Faraday discuté en introduction où la rotation du plan de polarisation est liée au champ magnétique et non à l'aimantation du milieu. Or, notamment dans les configurations les plus habituelles de magnétomètres (magnétomètre à double résonance, magnétomètre à effet Hanle), les moments magnétiques des atomes permettent une mesure du champ uniquement du fait du couple que ce champ exerce sur eux. Pour que ce couple ne soit pas nul, la direction du champ magnétique ne doit en aucun cas être parallèle à celle des moments magnétiques, et on ne peut donc pas parler dans ce cas d'effet Faraday à proprement parler, mais uniquement par abus de langage.

Il existe cependant un schéma de magnétométrie connu sous le nom de NMOR (pour « Non-linear Magneto-Optical Rotation) où un phénomène sensiblement équivalent à l'effet Faraday *stricto sensu* apparaît sur un gaz atomique. Ce schéma est caractérisé par les éléments suivants :

- une cellule remplie d'un milieu atomique, constitué selon la littérature d'atomes d'alcalins, est sujette à un seul faisceau optique, polarisé linéairement et accordé à la longueur d'onde d'une transition atomique, ou très proche de celle-ci, avec des intensités optiques inférieures à celles qui saturent la transition optique (au sens de l'émission stimulée), mais semblables ou supérieures à celles qui permettent que le taux de pompage optique soit semblable ou supérieur au taux de relaxation de la polarisation atomique du niveau bas du cycle de pompage optique ;
- la lumière est analysée par un analyseur de polarisation linéaire en sortie de cellule, ce qui permet de mesurer la rotation du plan de polarisation.

Dans ce schéma de magnétométrie, il apparaît trois effets magnéto-optiques selon le décalage entre la longueur d'onde de la lumière et celle de la transition atomique considérée :

- un effet Faraday linéaire sur une gamme large de longueur d'onde autour de la transition ;
- à proximité immédiate de la transition (moins d'une demi-largeur de raie), viennent se superposer à ce premier effet :
- l'effet Macaluso-Corbino qui donne lieu à des rotations de polarisation présentant une dépendance non monotone avec le champ magnétique ;
- la résonance NMOR, la seule réellement utilisée pour des mesures dans la littérature car elle présente une pente très forte dans le rapport rotation de polarisation/champ magnétique longitudinal.
- La Demanderesse a toutefois vérifié que ces deux derniers effets ne se prêtent pas à la mesure de courant insensible aux champs parasites car :
- la gamme de champ magnétique où la rotation de polarisation présente une dépendance linéaire avec le champ magnétique est très étroite : quelques nT pour le NMOR, quelques centaines de nT pour le Macaluso-Corbino, ce qui limite fortement la possibilité de mesurer des courants intenses en se servant de ces résonances, et sans utiliser un champ de compensation qui aboutirait à une consommation de courant très élevée ;
- ces effets ne sont pas insensibles aux champs magnétiques transverses de sorte que l'immunité aux courants parasites assurée par l'intégrale d'Ampère est perdue.

Ainsi, dans le cadre de l'invention, le faisceau optique fourni par la source optique 2 est décalé en longueur d'onde (i.e. désaccordé) par rapport au centre d'une raie de transition atomique du gaz atomique.

Le désaccord optimal peut être recherché expérimentalement, mais correspond d'une manière générale à une moitié de la largeur à mi-hauteur de la raie atomique considérée. Pour une recherche expérimentale, le critère est d'obtenir une dépendance linéaire de la rotation du plan de polarisation de la lumière en fonction du champ magnétique, et ce sur l'intégralité de la gamme dynamique de champ nécessaire à la mesure.

En exploitant ce décalage en longueur d'onde par rapport au centre de la raie transition atomique d'une moitié de la largeur à mi-hauteur de ladite raie, la Demanderesse a démontré expérimentalement sur les raies D0 et D2 de l'hélium qu'il est possible d'obtenir une mesure du courant indépendante (à mieux que le pour mille) de la présence ou pas de champs magnétiques parasites provenant de courants extérieurs à la boucle de lumière, d'aimants, du champ terrestre ou de matériaux présentant une aimantation rémanente significative. On relèvera que l'exploitation de la transition $D_2$, plutôt que les transitions $D_0$ ou $D_1$, est à privilégier, celle-ci permettant d'obtenir des niveaux de signal à bruit nettement plus favorables et ne présentant pas d'effets magnéto-optiques non linéaires pouvant perturber la mesure lorsque le champ local passe proche de zéro.

Dans un mode de réalisation possible de l'invention, le capteur peut également comprendre un modulateur de la longueur d'onde du faisceau optique fourni par la source de lumière et un système d'asservissement de la source de lumière configuré pour maintenir le décalage en longueur d'onde du faisceau optique par rapport au centre de la raie. La raie d'absorption présentant une symétrie paire autour d'une fréquence de résonance optique, si la modulation est réalisée avec une dépendance temporelle de type $\sin(\omega t)$, un signal permettant la mesure du courant est présent dans la composante en $\cos(\omega t)$ tandis qu'un signal représentatif d'un décalage du laser par rapport à la fréquence de résonance optique est présent dans la composante résiduelle en $\sin(\omega t)$ du signal de photodétection. Ainsi, cette modulation de la longueur d'onde permet de combiner une mesure du courant sur la symétrie paire du signal et une mesure du décalage en longueur d'onde vis-à-vis des signaux de symétrie impaire. Cette mesure du décalage peut être ainsi être utilisée comme signal d'erreur pour un asservissement d'un paramètre de contrôle de la source optique (par exemple le courant de pompe d'une diode laser) de manière à garder un parfait désaccord entre la longueur d'onde du faisceau optique et la raie atomique considérée.

Dans un autre mode de réalisation, le capteur peut en outre comprendre un modulateur configuré pour moduler l'amplitude ou la fréquence du faisceau optique fourni par la source de lumière. Le capteur peut ainsi exploiter l'effet AM-NMOR ou FM-NMOR (utilisation de la résonance NMOR en présence d'une modulation d'amplitude ou de fréquence du faisceau optique). Chacun de ces effets permet de récupérer l'indépendance aux champs transverses qu'il n'est pas possible d'assurer sur la résonance NMOR simple. L'avantage par rapport à l'effet Faraday linéaire est une pente bien plus avantageuse (100 fois plus forte) aboutissant à une relation signal-à-bruit plus favorable. Ce mode de réalisation s'avère ainsi avantageux pour mesurer des courants de faible intensité (tels que des courants de fuite) très précisément pour diagnostiquer, par exemple, le vieillissement (ou salissure) de structures qui sont censées fournir une très bonne isolation galvanique.

On notera qu'il est possible de combiner une modulation de longueur d'onde avec du AM-NMOR pour obtenir à la fois un asservissement de longueur d'onde et une mesure. Il est également possible de combiner une modulation de longueur d'onde avec du FM-NMOR en venant combiner deux modulations de longueur d'onde du laser : une première (celle du FM-NMOR) accordée au champ magnétique mesuré et donc rapide (plusieurs MHz en champ terrestre par exemple), et la deuxième pour l'asservissement du laser dont la fréquence peut être librement choisie.

L'invention n'est pas limitée au capteur précédemment décrit mais s'étend également à un procédé de mesure d'un courant à l'aide d'un tel capteur, notamment à un procédé de mesure d'un courant circulant dans un conducteur, comprenant les étapes consistant à :

- fournir, par une source de lumière, un faisceau optique polarisé linéairement,
- faire circuler ledit faisceau optique sur un chemin optique arrangé entre la source de lumière et un analyseur de polarisation, ledit chemin optique formant une trajectoire fermée autour du conducteur et ledit faisceau optique traversant une cellule contenant un gaz atomique lors de sa circulation sur le chemin optique
- réaliser, par l'analyseur de polarisation, une mesure différentielle de deux composantes de polarisation du faisceau optique ayant parcouru le chemin optique.

## Revendications

1. Capteur magnéto-optique (1, 10) d'un courant circulant dans un conducteur, comprenant :

   - une source de lumière (2) apte à fournir un faisceau optique polarisé linéairement,
   - un analyseur de polarisation (4) configuré pour réaliser une mesure différentielle de deux composantes de polarisation du faisceau optique polarisé linéairement ayant parcouru un chemin optique (OP) arrangé entre la source de lumière et l'analyseur de polarisation, ledit chemin optique formant une trajectoire fermée configurée pour être placée autour du conducteur, ledit capteur comprenant une cellule (3, C1-C4) contenant un gaz atomique agencée le long du parcours optique, le faisceau optique fourni par la source optique (2) étant décalé en longueur d'onde par rapport au centre d'une raie de transition atomique du gaz atomique.

2. Capteur magnéto-optique selon la revendication 1, dans lequel le faisceau optique fourni par la source optique (2) est décalé en longueur d'onde par rapport au centre de la raie transition atomique d'une moitié de la largeur à mi-hauteur de ladite raie.

3. Capteur magnéto-optique selon l'une des revendications 1 ou 2, dans lequel le gaz atomique est de l'hélium-4 et ladite raie est la raie D2.

4. Capteur magnéto-optique selon l'une des revendications 1 à 3, comprenant en outre un modulateur de la longueur d'onde du faisceau optique fourni par la source de lumière et un système d'asservissement de la source de lumière configuré pour maintenir le décalage en longueur d'onde du faisceau optique par rapport au centre de ladite raie.

5. Capteur magnéto-optique selon l'une des revendications 1 à 4, comprenant en outre un modulateur configuré pour moduler l'amplitude ou la fréquence du faisceau optique fourni par la source de lumière.

6. Capteur magnéto-optique selon l'une des revendications 1 à 5, comprenant des miroirs (M1-M4) agencés le long du parcours optique.

7. Capteur magnéto-optique selon la revendication 6, dans lequel la cellule (C) est annulaire.

8. Capteur magnéto-optique selon l'une des revendications 1 à 7, dans lequel l'analyseur de polarisation (4) est un analyseur de polarisation linéaire configuré pour réaliser une mesure différentielle d'une composante de polarisation verticale et d'une composante de polarisation horizontale du faisceau optique ayant parcouru le chemin optique.

9. Capteur magnéto-optique selon la revendication 8, dans lequel l'analyseur de polarisation linéaire comprend un séparateur de polarisation (W) apte à séparer sur un premier et un deuxième chemin la composante de polarisation verticale et la composante de polarisation horizontale et un photodétecteur (P1, P2) sur chacun des premier et deuxième chemins.

**10.** Capteur magnéto-optique selon l'une des revendications 1 à 9, dans lequel l'analyseur de polarisation est un analyseur de polarisation circulaire configuré pour réaliser une mesure différentielle d'une composante de polarisation circulaire droite et d'une composante de polarisation circulaire gauche du faisceau optique ayant parcouru le chemin optique.

**11.** Capteur magnéto-optique selon la revendication 10, dans lequel l'analyseur de polarisation circulaire comprend une lame quart d'onde, un séparateur de polarisation apte à séparer sur un premier et un deuxième chemin la composante de polarisation circulaire droite et la composante de polarisation circulaire gauche et un photodétecteur sur chacun des premier et deuxième chemins.

**12.** Procédé de mesure d'un courant circulant dans un conducteur, comprenant les étapes consistant à :

- fournir, par une source de lumière (2), un faisceau optique polarisé linéairement,
- faire circuler ledit faisceau optique sur un chemin optique (OP) arrangé entre la source de lumière et un analyseur de polarisation (4), ledit chemin optique formant une trajectoire fermée autour du conducteur,
- réaliser, par l'analyseur de polarisation (4), une mesure différentielle de deux composantes de polarisation du faisceau optique ayant parcouru le chemin optique, lequel faisceau optique traverse lors de sa circulation sur le chemin optique une cellule (3, C1-C4) contenant un gaz atomique, ledit faisceau optique étant décalé en longueur d'onde par rapport au centre d'une raie de transition atomique dudit gaz atomique.

**Patentansprüche**

**1.** Magnetooptischer Sensor (1, 10) für einen durch einen Leiter fließenden Stroms, umfassend:

- eine Lichtquelle (2), die dazu ausgelegt ist, einen linear polarisierten optischen Strahl zu liefern,
- einen Polarisationsanalysator (4), der dazu konfiguriert ist, eine Differenzmessung zweier Polarisationskomponenten des linear polarisierten optischen Strahls durchzuführen, der sich entlang eines optischen Pfads (OP) bewegt hat, der zwischen der Lichtquelle und dem Polarisationsanalysator angeordnet ist, wobei der optische Pfad eine geschlossene Bahn bildet, die dazu konfiguriert ist, um den Leiter herum platziert zu sein,

wobei der Sensor weiterhin eine Zelle (3, C1-C4) umfasst, die ein atomares Gas enthält und entlang des optischen Pfads angeordnet ist, wobei die Wellenlänge des durch die optische Quelle (2) gelieferten optischen Strahls in Bezug auf die Mitte einer atomaren Übergangslinie des atomaren Gases verschoben ist.

**2.** Magnetooptischer Sensor nach Anspruch 1, wobei die Wellenlänge des durch die optische Quelle (2) gelieferten optischen Strahls in Bezug auf die Mitte der atomaren Übergangslinie um die Hälfte der Halbwertsbreite der Linie verschoben ist.

**3.** Magnetooptischer Sensor nach einem der Ansprüche 1 oder 2, wobei das atomare Gas Helium-4 ist und die Linie eine D2-Linie ist.

**4.** Magnetooptischer Sensor nach einem der Ansprüche 1 bis 3, der ferner einen Modulator für die Wellenlänge des durch die Lichtquelle gelieferten optischen Strahls und ein Lichtquellen-Servosystem umfasst, das dazu konfiguriert ist, die Verschiebung der Wellenlänge des optischen Strahls in Bezug auf die Mitte der Linie aufrechtzuerhalten.

**5.** Magnetooptischer Sensor nach einem der Ansprüche 1 bis 4, der ferner einen Modulator umfasst, der dazu konfiguriert ist, die Amplitude oder die Frequenz des durch die Lichtquelle gelieferten optischen Strahls zu modulieren.

**6.** Magnetooptischer Sensor nach einem der Ansprüche 1 bis 5, der Spiegel (M1-M4) umfasst, die entlang des optischen Pfades angeordnet sind.

**7.** Magnetooptischer Sensor nach Anspruch 6, wobei die Zelle (C) ringförmig ist.

**8.** Magnetooptischer Sensor nach einem der Ansprüche 1 bis 7, wobei der Polarisationsanalysator (4) ein linearer Polarisationsanalysator ist, der dazu konfiguriert ist, eine Differenzmessung einer vertikalen Polarisationskomponente und einer horizontalen Polarisationskomponente des optischen Strahls durchzuführen, der sich entlang des optischen Pfades bewegt hat.

**9.** Magnetooptischer Sensor nach Anspruch 8, wobei der lineare Polarisationsanalysator einen Polarisationsteiler (W) umfasst, der dazu ausgelegt ist, die vertikale Polarisationskomponente und die horizontale Polarisationskomponente auf einen ersten und einen zweiten Pfad und einen Fotodetektor (P1, P2) jeweils auf den ersten und den zweiten Pfad aufzuteilen.

**10.** Magnetooptischer Sensor nach einem der Ansprüche 1 bis 9, wobei der Polarisationsanalysator ein zirkularer Polarisationsanalysator ist, der dazu konfiguriert ist, eine Differenzmessung einer rechten zirkularen Polarisationskomponente und einer linken zirkularen Polarisationskomponente des optischen Strahls durchzuführen, der sich entlang des optischen Pfads bewegt hat.

**11.** Magnetooptischer Sensor nach Anspruch 10, wobei der zirkulare Polarisationsanalysator eine Viertelwellenplatte und einen Polarisationsteiler umfasst, der dazu ausgelegt ist, die rechte zirkulare Polarisationskomponente und die linke zirkulare Polarisationskomponente auf einen ersten und einen zweiten Pfad und einen Fotodetektor jeweils auf den ersten und den zweiten Pfad aufzuteilen.

**12.** Verfahren zum Messen eines durch einen Leiter fließenden Stroms, das die folgenden Schritte umfasst:

- Liefern eines linear polarisierten optischen Strahls durch eine Lichtquelle (2),
- Veranlassen, dass der optische Strahl auf einem optischen Pfad (OP) fließt, der zwischen der Lichtquelle und einem Polarisationsanalysator (4) angeordnet ist, wobei der optische Pfad eine geschlossene Bahn um den Leiter herum bildet,
- Durchführen einer Differenzmessung zweier Polarisationskomponenten des optischen Strahls, der sich entlang des optischen Pfads bewegt hat, durch den Polarisationsanalysator (4), wobei der optische Strahl bei seiner Bewegung auf dem optischen Pfad eine Zelle (3, C1-C4) durchläuft, die ein atomares Gas enthält, wobei die Wellenlänge des optischen Strahls in Bezug auf die Mitte einer atomaren Übergangslinie des atomaren Gases verschoben ist.

**Claims**

**1.** Magneto-optical sensor (1, 10) for sensing a current flowing through a conductor, comprising:

- a light source (2) configured to provide a linearly-polarized optical beam,
- a polarization analyser (4) configured to perform a differential measurement of two polarization components of the linearly-polarized optical beam having travelled along an optical path (OP) arranged between the light source and the polarization analyser, said optical path forming a closed trajectory around the conductor,

wherein the magneto-optical sensor further comprises a cell (3, C1-C4) containing an atomic gas arranged along the optical path, the optical beam provided by the light source (2), being shifted in wavelength from a center of an atomic transition line of the atomic gas.

**2.** Magneto-optical sensor according to claim 1, wherein the optical beam provided by the light source (2) is shifted in wavelength from a center of the atomic transition line by half the full width at half maximum of said line.

**3.** Magneto-optical sensor according to any of the claims 1 or 2, wherein the atomic gas is helium-4 and said line is a D2 line.

**4.** Magneto-optical sensor according to any of the claims 1 to 3, further comprising a modulator configured to modulate a wavelength of the optical beam provided by the optical source and a light source servo-control system configured to maintain the shift in wavelength of the optical beam from the center of said line.

**5.** Magneto-optical sensor according to any of the claims 1 to 4, further comprising a modulator configured to modulate an amplitude or a frequency of the optical beam provided by the optical source.

**6.** Magneto-optical sensor according to any of the claims 1 to 5, further comprising mirrors (M1-M4) arranged along the optical path.

**7.** Magneto-optical sensor according to claim 6, wherein the cell (C) is annular.

**8.** Magneto-optical sensor according to any of the claims 1 to 7, wherein the polarization analyzer (4) is a linear polarization analyzer configured to perform a differential measurement of a vertical polarization component and of a horizontal polarization component of the optical beam that has travelled along the optical path.

**9.** Magneto-optical sensor according to claim 8, wherein the linear polarization analyzer comprises a polarization splitter (W) configured to split the vertical polarization component and the horizontal polarization component on a first and a second path, and a respective photodetector (P1, P2) being arranged on each of the first and second paths.

**10.** Magneto-optical sensor according to any of the claims 1 to 9, wherein the polarization analyzer is a circular polarization analyzer configured to perform a differential measurement of a right-hand circular polarization component and of a left-hand circular polarization component of the optical beam that has travelled along the optical path.

**11.** Magneto-optical sensor according to claim 10, wherein the circular polarization analyzer comprises a quarter-wave plate, a polarization splitter configured to split the right-hand circular polarization component and the left-hand circular polarization component on a first and a second path, and a respective photodetector arranged on each of the first and second paths.

12. Method for measuring a current flowing through a conductor, the method comprising:

providing, by using a light source (2): a linearly-polarized optical beam

causing said optical beam to flow along an optical path (OP) arranged between the light source and a polarization analyzer (4), said optical path forming a closed trajectory around the conductor,

performing, by using the polarization analyzer: a differential measurement of two polarization components of the optical beam that has travelled along the optical path, said optical beam passes through, along the optical path, a cell (3, C1-C4) containing an atomic gas, the optical beam being shifted in wavelength from a center of an atomic transition line of the atomic gas.

FIG. 1

FIG. 2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2019122693 A1
- US 6154022 A